# EUROPEAN PATENT SPECIFICATION

(11) **EP 0 532 692 B1**
(45) Date of publication and mention of the grant of the patent: **17.01.1996**
(21) Application number: 91912830.6
(22) Date of filing: 06.06.1991
(51) Int. Cl.: G01V 3/00, H01F 7/06, G01R 33/38

(54) **SHIELDED GRADIENT COIL FOR NUCLEAR MAGNETIC RESONANCE IMAGING**
ABGESCHIRMTE GRADIENTSPULE FÜR NMR-ABBILDUNG
BOBINE A GRADIENT BLINDEE UTILISEE EN IMAGERIE PAR RESONANCE MAGNETIQUE NUCLEAIRE

(30) Priority: 06.06.1990 US 534142; 29.06.1990 US 545888
(43) Date of publication of application: 24.03.1993
(73) Proprietor: ADVANCED NMR SYSTEMS INC., Woburn, MA 01801 (US)
(72) Inventor: RZEDZIAN, Richard, Lexington, MA 02173 (US); MARTIN, Charles, Arlington, MA 02175 (US)
(74) Representative: Deans, Michael John Percy
(86) International application number: US9103996
(87) International publication number: WO9119209

(56) References cited:
- EP-A- 0 304 126
- GB-A- 2 170 957
- GB-A- 2 229 820
- US-A- 4 634 975
- US-A- 4 642 569
- US-A- 4 733 189
- US-A- 4 737 716
- US-A- 4 749 338
- US-A- 4 906 934

## Description

This invention relates to gradient coils in nuclear magnetiC resonance imaging systems.

Nuclear magnetic resonance (NMR) systems may be used as medical diagnostic tools. Generally, they consist of a region that holds the patient or sample surrounded by a set of coils. The outermost coil is often a superconducting DC coil which provides a strong, constant magnetic field that polarizes the nuclei in the molecules of the sample or the patient's body. A smaller RF coil sits concentrically within the DC coil, and generates a time-varying RF field that excites the nuclei and detects their response to this excitation. A coil assembly, generally referred to as the "gradient coil", occupies the space between the above coils and generates a time-varying spatially dependent audio frequency magnetic field (usually a linear gradient field) which causes'the response frequency of the nuclei to depend on their positions within the field. This imparted spatial information allows the generation of an image of the areas excited and detected by the RF coil.

Such a gradient coil assembly usually consists of a set of three primary coils (X, Y and Z) which may each be manufactured by winding a pattern of conductors on the surface of a cylinder. Each of these coils may be shielded with another pattern of conductors wound on another cylindrical surface which surrounds the coils. Coils of this type are presented in U.S. patents 4,737,716 and 4,794,338, respectively entitled "Self-Shielded Gradient Coils for Nuclear Magnetic Resonance Imaging" and "Balanced Self-Shielded Gradient Coils", both of Roemer et al.

Gradient coils, because they operate at audio frequencies, can be the source of high levels of acoustic noise. This is particularly true for coils used in high speed imaging, as higher frequencies and higher currents are used.

It is also known to use Litz wire in transformers and coils as it reduces skin effect conduction and thus exhibits decreased resistance for a given conductor diameter. U.S. patent 4,549,042 entitled "Litz Wire for Decreasing Skin Effect at High Frequency" of Akiba discusses this effect.

EP-A-0 304 126 NV Philips' Gloeilampenfabrieken discloses an MRI gradient coil disposed concentrically inside an eddy current shield coil distributed on a cylinder surface.

US-A-4 794 338 Roemer et al discloses a primary gradient coil carried on a cylindrical substrate. Shielding coils are also disclosed. US-A-4 737 716 Roemer et al also shows concentric primary and shielding coils.

US-A-4 733 189 of Punchard et al shows spaced primary and shielding coils with support struts located at spaced periodic intervals throughout the annular region separating the coils.

GB-A-2 170 957 of Oxford Magnet Technology Limited describes a coil assembly for NMR imaging in which a cylindrical former is comprised of four axially spaced rings which are joined by axially extending members. The gradient coils are wound on the outer surface of this former.

We described below a unitary, generally cylindrical member on which the primary and shielding coils are supported (e.g., the primary coil on the interior surface and the shielding coil on the exterior surface). By supporting both coils on a unitary member it is possible to take advantage of the antiphase relationship between the primary and shielding coil currents and thereby reduce the acoustic noise generated by the gradient coil assembly. The unitary member need not be entirely solid, but could include voids, so long as it is sufficiently stiff and/or massive to reduce acoustic noise.

The invention accordingly provides, in a first aspect thereof, for use in magnetic resonance imaging, a gradient coil assembly comprising: a generally cylindrical member, a primary coil placed about a cylindrical surface on or within said member, said surface having a longitudinal axis, and a shielding coil; characterized in that said shielding coil is placed about a second cylindrical surface on or within said member and outside of said first cylindrical surface, said second cylindrical surface being in substantially concentric alignment with said firstmentioned cylindrical surface, to maintain said primary and shielding coils in substantial alignment; and in that said member is unitary and substantially solid throughout and has sufficient stiffness and/or mass to provide anti-phase coupling between said primary and shielding coils to reduce acoustic noise output.

In a second and alternative aspect of this invention, we provide a'manufacturing process for producing a magnetic resonance imaging coil assembly, said manufacturing process comprising the steps of:
(1) creating a first cylindrical surface on a unitary member, said first surface being substantially aligned with a longitudinal axis;
(2) creating a second cylindrical surface on said member, said second cylindrical surface being substantially aligned with said longitudinal axis;
(3) placing a primary coil on said first cylindrical surface; and
(4) placing a shielding coil on said second cylindrical surface;
said unitary member being substantially solid throughout and having sufficient stiffness and/or mass to provide anti-phase coupling between said primary and shielding coils to reduce acoustic noise output.

In preferred embodiments, the unitary member is formed by starting with a mandrel to which the primary coil is applied, and then successively adding layers each having a cylindrical outer surface aligned with the same longitudinal axis. Each new cylindrical surface is formed by adding material and then removing some of the material while rotating the member about the longitudinal axis (e.g. turning on a lathe, or passing a blade past a still liquid skim coat). Additional primary or shielding coils are applied after each new aligned, cylindrical surface is formed.

In still other preferred embodiments, the unitary member is formed by starting with a cylinder, and adhering the primary coil to the interior of the cylinder and the shielding coil to the exterior.

One or more correction coils may be located outside of the shielding coils to achieve substantial cancellation of any magnetic field present there as the result of misalignment between the primary and shielding coils.

Litz wire may be used in one or more of the primary coils (and preferably also the shielding coils).

Our gradient coil assembly has the advantage of reduced audio noise as the primary and the shield coil windings are both supported on the same unitary member, thus reducing vibration. The currents flow through the coil and shield in an anti-phase fashion and thus their associated magneto-motive forces tend to cancel if appropriately coupled by the unitary member. The mass and stiffness added to the assembly by the unitary member also contributes to reducing the amplitude of audible noise.

The coil assembly may be aligned with a high degree of precision. Correction coils may compensate for any remaining misalignment of the gradient coil assembly or the main magnet, and may be retro-fitted on existing systems.

The use of Litz wire in the gradient coils not only provides the advantages of reduced skin effect within the conductors, but also provides advantages due to reduced eddy currents and proximity effect caused by adjacent conductors and adjacent coil layers. These reductions in skin effect, proximity effect, and induced eddy currents lead to lower coil resistance which, in turn, leads to lower power consumption and cooling requirements. The lower power consumption can allow the use of less expensive gradient amplifiers. The reduced proximity effect and lower induced eddy currents from adjacent conductors and adjacent coil layers may provide improved imaging quality.

Other features and advantages will be apparent from the following description of a preferred embodiment.

In the drawings:

FIG. 1 is a cross-section of an NMR coil apparatus.

FIG. 2 is a cross-section of an NMR gradient coil assembly.

FIG. 3 is a detail of the outer coil layers in the area shown by circle "A" in FIG. 2.

FIG. 4 is a partial exploded view of the NMR gradient coil assembly, showing the X and Y coils and shields removed from their embedded Z counterparts.

FIG. 5 is a partial winding pattern for the X primary coil.

FIG. 6 is a flowchart illustrating steps involved in manufacturing a coil assembly.

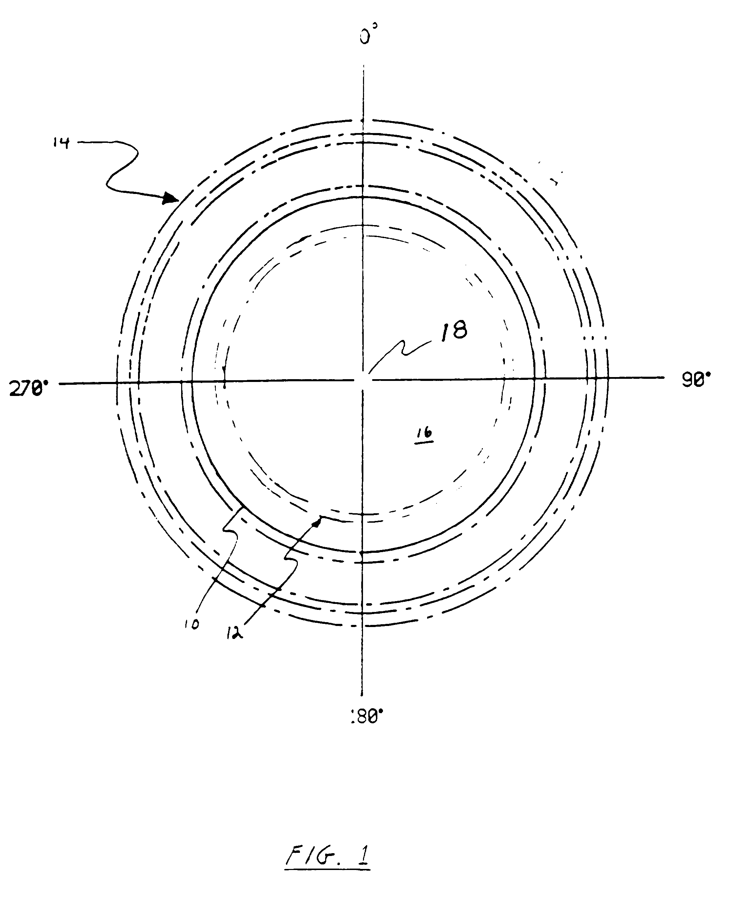

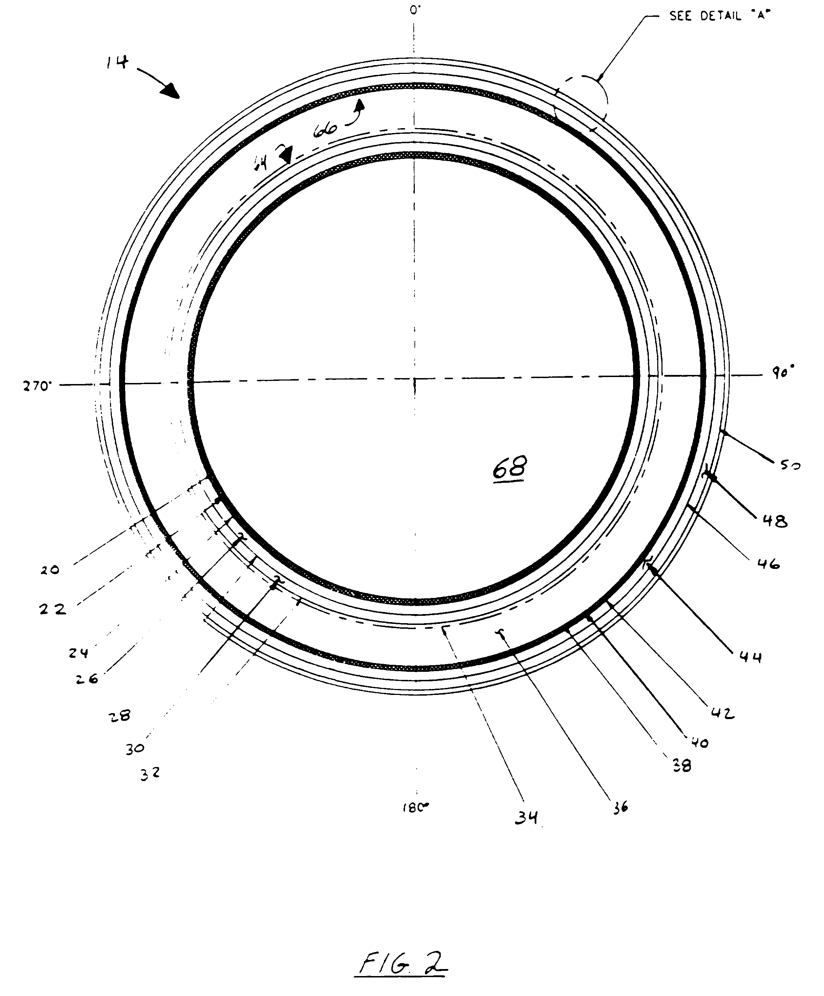

Referring to FIG. 1, a diagnostic NMR apparatus includes a cavity 16 for examining a patient, surrounded by a cylindrical RF coil 12. This coil 12 alternatively provides an RF field that excites the nuclear magnetic resonance phenomenon in the nuclei of the molecules of the patient's body and acts as a detector to detect the response of the nuclei to their overall excitation by the NMP. apparatus. The RF coil is surrounded by an RF shield 10.

The RF shield is, in turn, surrounded by a gradient coil assembly 14. The gradient coil assembly is made up of a series of coils which generate audio frequency gradient fields that, taken together, allow spatial resolution of the NMR phenomenon within the cavity. These gradient coils operate at frequencies up to 7 kHz. A further coil (not shown), known as the main magnet, surrounds the gradient coil assembly. The RF coil, shield, gradient coil assembly, and main magnet are concentrically arranged around the center of the NMR apparatus 18.

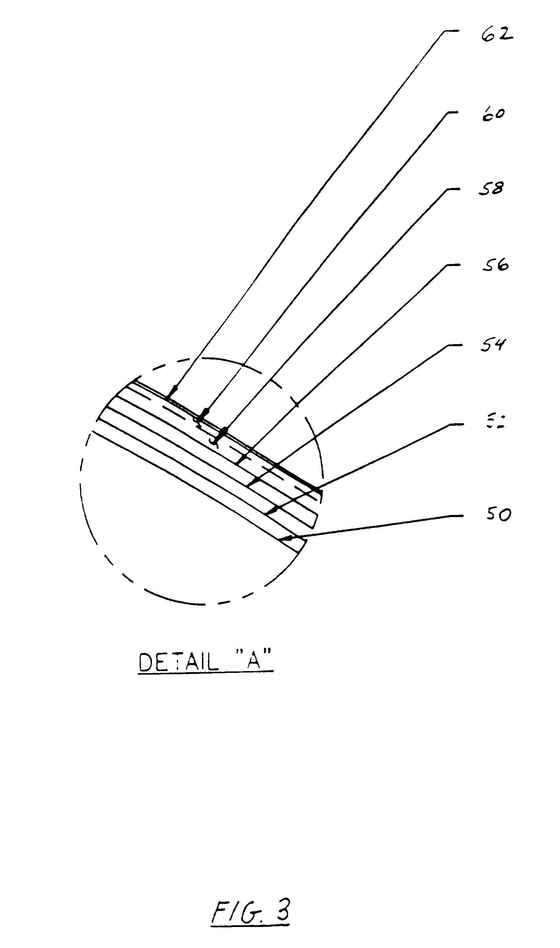

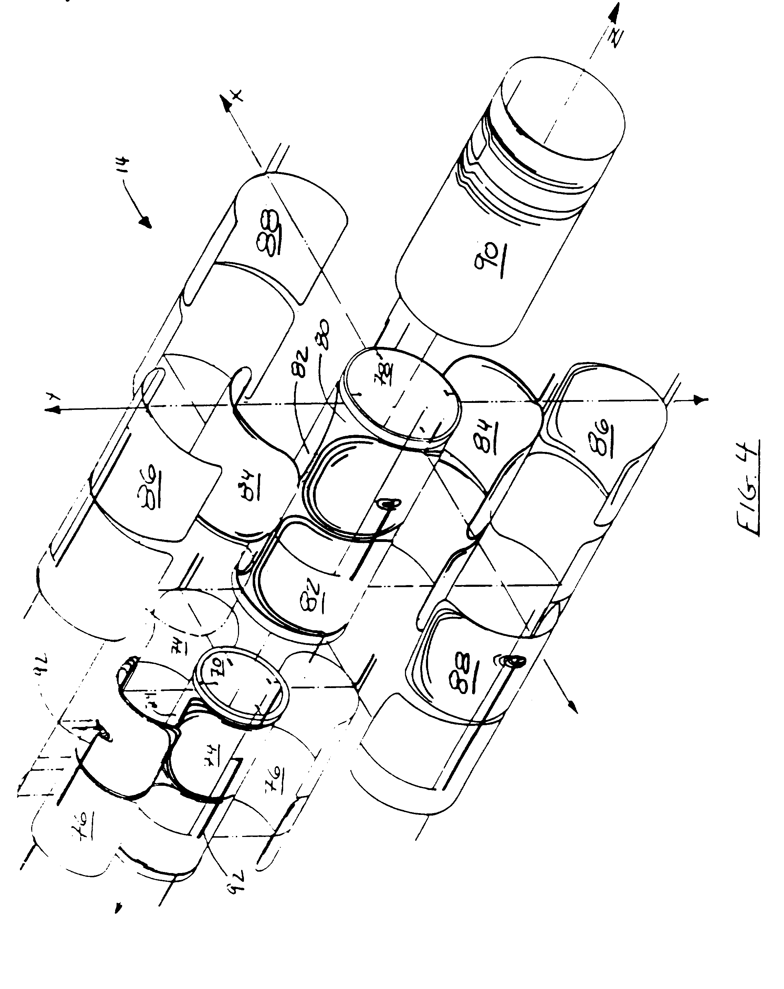

Referring to FIGS. 2 and 4, the gradient coil assembly 14 consists of two sets of coils arranged concentrically. The innermost set 64 includes the primary gradient coils, and the outermost set 66 comprises the shield, shim and correction coils.

The inner surface 20 of the gradient coil assembly defines the inside surface of the Z-coil 70. This Z-coil may be wound on a former (not shown) which will remain part of the system or it may be wound on a mandrel 68 that is later removed, as is shown in the figure. The assembly and winding procedure will be discussed in more detail later. The Z-coil is wound as a cylindrical spiral and it provides a magnetic field gradient in the Z-direction within the cavity 16.

The gradient coils in the assembly are wound with Litz wire. The Litz wire used is an 805-strand Litz wire available from New England Electric Wire, of Lisbon, New Hampshire. Litz wire is used in many applications for its reduced resistance at high frequencies, due to a lower skin effect. This is an advantage in that the amplifiers that drive the coils need to deliver less power and consequently may be made less expensively. In addition, the coil produces less heat and consequently requires less cooling. It has also been found that Litz wire has the advantage of reducing proximity effect in the gradient coil assembly.

Proximity effect is the effect of the magnetic field caused by current flowing in one conductor on the current distribution in an adjacent conductor. Reducing the proximity effect between adjacent conductors within a coil decreases the resistance in the coil. Reducing the proximity effect between conductors in separate coils will also decrease the resistance of the coils and, furthermore, may result in reduced imaging distortion, caused by circulating eddy currents in solid conductors.

A current-carrying wire may also induce eddy currents in its neighbors. The use of Litz wire reduces the amount of current which may be induced in an adjacent conductor by fragmenting its cross-section. The reduction of this proximity effect within a coil contributes to a lower resistance of the coil, and the reduction of this effect between separate coils contributes to lower coil resistances and lower imaging distortion. This reduced distortion results in more accurate imaging of the sample or patient.

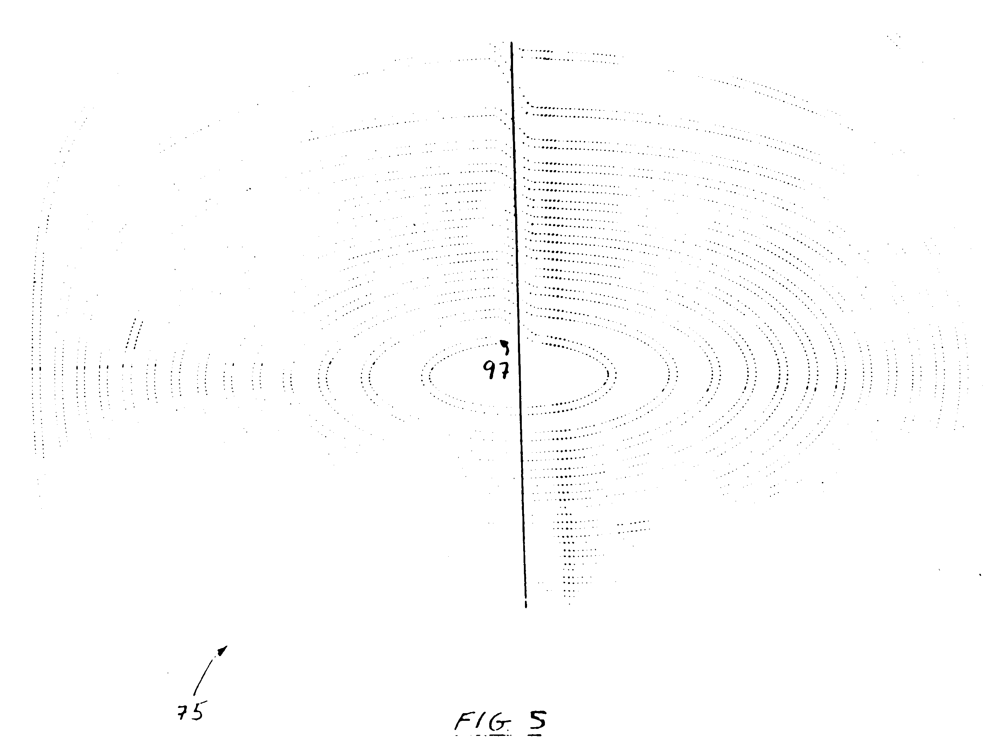

The manufacturing process begins with the Z-coil being embedded in, and axially surrounded by, an epoxy layer 22 which has an outer surface 24 that serves as an X-coil winding surface. The X-coil 74 includes four generally spirally wound segments 75 (FIG. 5) of wire that are curved to conform to the curvature of the X-coil winding surface 24 (as shown, for example, in U.S. Patents Nos. 4,737,716 and 4,794,338). The center leads 97 of these segments are connected by bus bars 92. The X-coil provides a linear gradient in the X direction within the cavity 16.

The X-coil is embedded in, and axially surrounded by, a second epoxy layer 26 which has an outer surface 28 on which the Y-coil 76 is wound. The Y-coil is similar to the X-coil, except that it is displaced around the cylinder by 90° with respect to the X-coil. This may be seen in FIG. 4. The Y-coil provides a time-varying linear gradient in the Y direction within the cavity 16.

A third epoxy layer 30 embeds and surrounds the Y-coil and provides a winding surface 32 for coolant tubes 34. These tubes cool the entire assembly. The tubes are surrounded by a wider central epoxy layer 36 which separates the primary coils from the outer coils. It is advantageous to separate the primary and outer coils by a large distance, for it reduces the power requirement of each shielded pair and also provides for a stronger overall gradient within the cavity.

The innermost shield coil is the Z-shield 78, which is wound on the outer surface 38 of the central epoxy layer 36. This shield is similar to the Z-coil, except that it is wound less densely. Its purpose is to provide a magnetic field that cancels that of the Z-coil outside of the gradient coil assembly. This prevents unwanted interaction with the main magnet and other objects outside of the coil.

The X-shield 82 and Y-shield 84 are wound on the surfaces 42, 46 of epoxy layers 40, 44, much as their associated coils were. These coils are also essentially sparser versions of their associated primary coils. It is noted that the order in which the coils are wound within each of the two sets is of little consequence, as long as the shield coils are designed to properly cancel their associated primary coil fields outside of the gradient coil assembly.

Outside of the shield coils is a set of shim coils which are shown in FIGS. 3 and 4. This set of shim coils includes a Y-shim 86, an X-shim 88, and a Z-shim 90 which are mounted on epoxy layer surfaces 50, 52, 54. These shims are powered with DC current, and allow small adjustments of the static field of the main magnet.

Outside of the shim coils, there is a Z-correction coil 58 (not shown in FIG. 4) which is wound on the outer surface 56 of a penultimate epoxy layer. This coil is provided to compensate for the field generated by any misalignment that may exist between the Z-coil and the Z-shield by generating a correction field which cancels the field due to the misalignment. Similar correction coils may also be provided for X or Y orientations, if needed. Correction coils may not be needed at all if the coils are sufficiently well aligned. If the corrections needed are linear in nature, the shim coils may be used for achieving the corrections.

It should be noted that the addition of correction coils will permit less demanding tolerances in the alignment and/or manufacturing processes, and may thus reduce the cost of achieving acceptable alignment. It should also be noted that this type of correction coil may be retro-fitted to existing systems. The particular configuration of correction coils will depend on the field resulting from the relative mechanical tolerances among the layers of that NMR system.

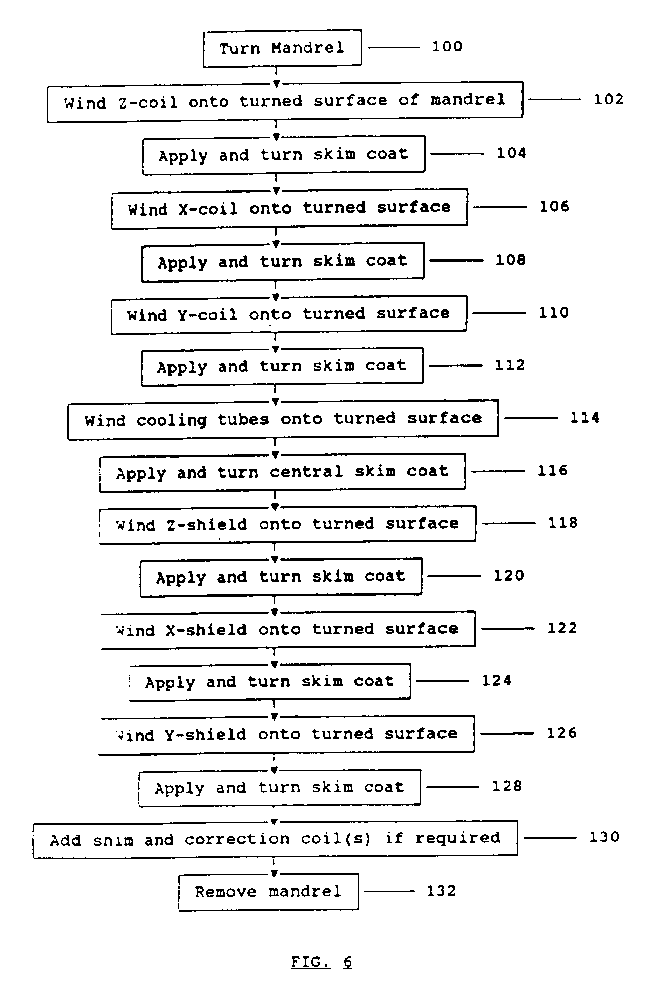

These mechanical tolerances may be minimized by manufacturing the coil assembly on a lathe. Referring to FIG 6, initially, a mandrel 68 is positioned in a lathe and turned 100 to yield a cylindrical mandrel with an outer surface that is aligned with the axis of the lathe. The Z-coil is then wound upon the mandrel and a suitable material, such as an epoxy is added on the outer surface of the Z-coil. The epoxy used should preferably be thixotropic, have a high thermal conductivity, present minimal shrinkage on setting, and be such that it may be cut on a lathe. This epoxy is allowed to set and is then turned 104 in order to produce a second outer surface that is also aligned with the axis of the lathe. The X-coil is then wound 106 on this surface, and the process is repeated for the Y-coil (steps 108-110) and cooling tubes (steps 112-114).

This completes the primary layers. A further layer of epoxy is added on the outside of the cooling tubes which will separate the primary layers and the outer layers. As mentioned earlier, this central layer is wider than the others and is therefore more suited to formation by molding, than it is to simple addition of epoxy. This molding operation is performed by surrounding the partial gradient coil assembly with an essentially cylindrical clam-shell mold, filling it with epoxy (Concresive, an adhesive filler available from Adhesive Engineering, San Carlos, California) used on the other layers, and allowing it to harden. Once the epoxy has hardened, the mold is removed, and the outer surface of the newly formed layer is turned to align it with the axis of the assembly, as were the earlier layers (step 116). It should be noted that this layer can also be formed with voids in it, or it may be formed in separate pieces. This would allow, for example, the use of a reduced amount of epoxy and/or the provision of locations for reinforcement members.

The Z-shield, X-shield, and Y-shield are then built up on the assembly in the same way as were the coils (steps 118-126). Correction and shim coils may also be added in a similar fashion (steps 128-130). A final epoxy layer 60 and a coat of epoxy paint 62 may be added to protect the outside surface of the gradient coil assembly (FIG. 3).

The mandrel is then removed (132), yielding a gradient coil assembly whose alignment between layers depends only on the tolerance of a single lathe and which has misalignment errors that are non-additive. It is noted that no complicated post-construction alignment procedures are needed, as would be necessary when assembling separate primary and outer coil assemblies.

During operation of the gradient coil assembly, acoustic noise is generated due to vibrations caused by the magneto-motive forces developed on the current-carrying wires within the high static magnetic field of the main magnet. Since the coil currents are modulated at audio frequencies, audio frequency sounds are produced. These may be of very high amplitude; in some cases being loud enough to damage the patient's hearing. The fact that the primary layers and the outer layers are held together in one integral piece with a turned central layer 36 reduces the audio noise produced by the coil assembly. This is true because the currents in the shields and coils are in opposing phase with respect to each other, so that their respective magneto-motive forces tend to cancel each other when the shields and coils are coupled together by the stiff and massive cylinder between them.

Other embodiments are feasible.

For example, there are other methods of manufacturing an integral piece that carries the primary coils on the inside and the shielding coils on the outside. E.g., the coils could be wound on separate cylindrical formers and the space between these formers could be filled with a filler. In this method, it is necessary to use a filler which shrinks very little while hardening, or the coil may lose its alignment. Concresive, an adhesive filler available from Adhesive Engineering (San Carlos, California) contains a substantial amount of sand and therefore tends to exhibit little shrinkage, making it a good choice. This sand-filled adhesive could also be used in the earlier-described molding process.

The assembly could also be made by first creating the single piece central cylindrical former. The primary coils are then placed on the inside surface of the former and the shielding coils are placed on the outside of the former. The coils are held to the former with an adhesive, and may be wound upon each other, or separated by layers of turned epoxy as described above. As is the case for a molded central layer, this former can include substantial voids, provided that it is stiff enough and/or massive enough to reduce the noise output of the assembly.

Alternatively, a light former with substantial voids could be used during turning, and the voids could be filled with epoxy thereafter. Jigs could also be used to maintain alignment during turning, and be removed upon hardening of the epoxy.

Instead of building up the central cylinder (on which the primary and shielding coils are supported) by turning successive layers on a lathe, skim coats could be applied and concentric, cylindrical surfaces formed by rotating the cylinder past a blade while the skim coats are still wet. Alternatively, grinding or milling steps could replace turning on a lathe. In each case, however, material is added to the cylinder in such a way as to create a new cylindrical surface concentric with a common axis.

## Claims

1. For use in magnetic resonance imaging, a gradient coil assembly comprising: a generally cylindrical member, a primary coil placed about a cylindrical surface on or within said member, said surface having a longitudinal axis, and a shielding coil; characterized in that said shielding coil is placed about a second cylindrical surface on or within said member and outside of said first cylindrical surface, said second cylindrical surface being in substantially concentric alignment with said firstmentioned cylindrical surface, to maintain said primary and shielding coils in substantial alignment; and in that said member is unitary and substantially solid throughout and has sufficient stiffness and/or mass to provide anti-phase coupling between said primary and shielding coils to reduce acoustic noise output.

2. A gradient coil assembly according to Claim 1, further characterized in that said unitary, generally cylindrical member comprises a succession of layers each having a cylindrical surface in substantial concentric alignment with said first cylindrical surface.

3. A gradient coil assembly according to Claim 2, further characterized in that said layers are built up by adding material to the exterior of said member and removing excess material to form said concentric cylindrical surface.

4. A gradient coil assembly according to Claim 3, further characterized in that said material is removed by turning on a lathe.

5. A gradient coil assembly according to Claim 1, further characterized in that
said unitary member comprises two cylindrical members, one of which supports said primary coil and the other of which supports said shielding coil, the cylindrical members having been aligned to bring said primary and shielding coils into substantial alignment, and a filler material having been inserted between the members to bond the members together and to fill at least some of the space between the members.

6. A gradient coil assembly according to Claim 1, further characterized in that said unitary member comprises a single cylindrical member having concentrically aligned interior and exterior cylindrical surfaces, in that said primary coil is adhered to the interior cylindrical surface, and in that said shielding coil is adhered to the exterior cylindrical surface.

7. A gradient coil assembly according to Claim 1, further characterized in comprising one or more additional primary coils and one or more additional shielding coils, with each coil applied to a cylindrical surface substantially concentrically aligned with said first and second cylindrical surfaces.

8. A gradient coil assembly according to Claim 1, further characterized in including a correction coil surrounding said shielding coil, said correction coil substantially cancelling the field outside of the gradient coil assembly produced by any misalignment between said primary coil and said shielding coil.

9. A gradient coil assembly according to Claim 1, further characterized in that said primary coil is wound with Litz wire.

10. A gradient coil assembly according to Claim 9, further characterized in that said shielding coil is wound with Litz wire.

11. A manufacturing process for producing a magnetic resonance imaging coil assembly, said manufacturing process comprising the steps of:
(1) creating a first cylindrical surface on a unitary member, said first surface being substantially aligned with a longitudinal axis;
(2) creating a second cylindrical surface on said member, said second cylindrical surface being substantially aligned with said longitudinal axis;
(3) placing a primary coil on said first cylindrical surface; and
(4) placing a shielding coil on said second cylindrical surface;
said unitary member being substantially solid throughout and having sufficient stiffness and/or mass to provide anti-phase coupling between said primary and shielding coils to reduce acoustic noise output.

12. A manufacturing process according to Claim 11, wherein said primary coil is formed on a mandrel, the surface of said mandrel providing said first cylindrical surface, and wherein said member is formed by adding material over said primary coil to produce said second cylindrical surface.

13. A manufacturing process according to Claim 12, wherein more than the finished amount of material is initially added and then material is removed to produce said second cylindrical surface.

14. A manufacturing process according to Claim 13, wherein material is removed by turning on a lathe.

15. A manufacturing process according to Claim 13, wherein material is removed by rotating said member about said longitudinal axis and removing material while it is still in a liquid state.

16. A manufacturing process according to Claim 11, wherein a plurality of primary coils and a plurality of shielding coils are applied, each being applied to a different cylindrical surface in substantial concentric alignment with said longitudinal axis.

17. A manufacturing process according to Claim 13, wherein a plurality of primary coils and a plurality of shielding coils are applied, each being applied to a different cylindrical surface formed successively by adding material over earlier formed cylindrical surfaces and applied coils.

## Patentansprüche

1. Im Zusammenhang mit Kernresonanzabbildung zu verwendende Gradientspulengruppe, umfassend: ein allgemein zylindrisches Glied, eine um eine zylindrische Oberfläche an dem besagten Glied oder innerhalb des besagten Glieds angeordnete Primärspule, wobei die besagte Oberfläche eine Längsachse aufweist, und eine Abschirmspule; dadurch gekennzeichnet, daß die besagte Abschirmspule um eine zweite zylindrische Oberfläche an dem besagten Glied oder innerhalb des besagten Glieds und außerhalb der besagten ersten zylindrischen Oberfläche angeordnet ist, wobei die besagte zweite zylindrische Oberfläche mit der besagten erstgenannten zylindrischen Oberfläche im wesentlichen konzentrisch ausgerichtet ist, um die besagte Primärspule und die besagte Abschirmspule im wesentlichen ausgerichtet zu erhalten; sowie dadurch, daß das besagte Glied einstückig und im wesentlichen durchwegs fest ist und ausreichende Steifigkeit und/oder Masse besitzt, um zwecks Einschränkung der Abgabe akustischer Störungen gegenphasige Koppelung zwischen der besagten Primärspule und der besagten Abschirmspule zu bewirken.

2. Eine Gradientspulengruppe nach Anspruch 1, des weiteren dadurch gekennzeichnet, daß das besagte einstückige, allgemein zylindrische Glied eine Folge von Schichten umfaßt, von denen jede eine zylindrische Oberfläche aufweist, die im wesentlichen konzentrisch mit der besagten ersten zylindrischen Oberfläche ausgerichtet ist.

3. Eine Gradientspulengruppe nach Anspruch 2, des weiteren dadurch gekennzeichnet, daß die besagten Schichten durch Hinzufügen von Material zu der Außenseite des besagten Glieds und Entfernen von überschüssigem Material zwecks Bildung der besagten konzentrischen zylindrischen Oberfläche aufgebaut sind.

4. Eine Gradientspulengruppe nach Anspruch 3, des weiteren dadurch gekennzeichnet, daß das besagte Material durch Drehen auf einer Drehmaschine entfernt wird.

5. Eine Gradientspulengruppe nach Anspruch 1, des weiteren dadurch gekennzeichnet, daß das besagte einstückige Glied zwei zylindrische Glieder umfaßt, von denen das eine die besagte Primärspule abstützt und von denen das andere die besagte Abschirmspule abstützt, wobei die zylindrischen Glieder so ausgerichtet wurden, daß die besagte Primärspule und die besagte Abschirmspule im wesentlichen ausgerichtet werden, und wobei ein Füllstoff zwischen die Glieder eingeführt wurde, um die Glieder miteinander zu verbinden und mindestens einen Teil des Zwischenraums zwischen den Gliedern auszufüllen.

6. Eine Gradientspulengruppe nach Anspruch 1, des weiteren dadurch gekennzeichnet, daß das besagte einstückige Glied ein einziges zylindrisches Glied mit konzentrisch ausgerichteten inneren und äußeren zylindrischen Oberflächen aufweist, daß die besagte Primärspule haftend an die innere zylindrische Oberfläche angebracht wird, sowie dadurch, daß die besagte Abschirmspule haftend an die äußere zylindrische Oberfläche angebracht wird.

7. Eine Gradientspulengruppen nach Anspruch 1, des weiteren dadurch gekennzeichnet, daß sie eine oder mehr zusätzliche Primärspulen und eine oder mehr zusätzliche Abschirmspulen umfaßt, wobei jede Spule auf eine im wesentlichen konzentrisch mit der besagten ersten und der besagten zweiten zylindrischen Oberfläche ausgerichtete zylindrische Oberfläche aufgetragen ist.

8. Eine Gradientspulengruppe nach Anspruch 1, des weiteren dadurch gekennzeichnet, daß
sie eine die besagte Abschirmspule umgebende Korrektionsspule umfaßt, wobei die besagte Korrektionsspule das durch etwaige Fehlausrichtung der besagten Primärspule im Verhältnis zu der besagten Abschirmspule erzeugte Feld außerhalb der Gradientspulengruppe im wesentlichen aufhebt.

9. Eine Gradientspulengruppe nach Anspruch 1, des weiteren dadurch gekennzeichnet, daß die besagte Primärspule mit Litzendraht umwickelt ist.

10. Eine Gradientspulengruppe nach Anspruch 9, des weiteren dadurch gekennzeichnet, daß die besagte Abschirmspule mit Litzendraht umwickelt ist.

11. Ein Herstellungsverfahren zur Herstellung einer zur Verwendung im Zusammenhang mit Kernresonanzabbildung bestimmten Spulengruppe, wobei das besagte Herstellungsverfahren die folgenden Stufen umfaßt:
(1) Erzeugung einer ersten zylindrischen Oberfläche an einem einstückigen Glied, wobei die besagte erste Oberfläche im wesentlichen mit einer Längsachse ausgerichtet ist;
(2) Erzeugung einer zweiten zylindrischen Oberfläche an dem besagten Glied, wobei die besagte zweite zylindrische Oberfläche im wesentlichen mit der besagten Längsachse ausgerichtet ist;
(3) Anbringung einer Primärspule an die besagte erste zylindrische Oberfläche; und
(4) Anbringung einer Abschirmspule an die besagte zweite zylindrische Oberfläche;
wobei das besagte einstückige Glied im wesentlichen durchwegs fest ist und ausreichende Steifigkeit und/oder Masse besitzt, um zwecks Einschränkung der Abgabe akustischer Störungen gegenphasige Koppelung zwischen der besagten Primärspule und der besagten Abschirmspule zu bewirken.

12. Ein Herstellungsverfahren nach Anspruch 11, bei dem die besagte Primärspule auf einem Dorn geformt wird, wobei die Oberfläche des besagten Dorns die besagte erste zylindrische Oberfläche bildet, und bei dem das besagte Glied durch Hinzufügen von Material oberhalb der besagten Primärspule gebildet wird, um die besagte zweite zylindrische Oberfläche zu erzeugen.

13. Ein Herstellungsverfahren nach Anspruch 12, bei dem anfänglich mehr Material hinzugefügt wird, als dem Endzustand entspricht, worauf Material entfernt wird, um die besagte zweite zylindrische Oberfläche zu erzeugen.

14. Ein Herstellungsverfahren nach Anspruch 13, bei dem Material durch Drehen auf einer Drehmaschine entfernt wird.

15. Ein Herstellungsverfahren nach Anspruch 13, bei dem Material durch Rotieren des besagten Glieds um die besagte Längsachse und Entfernen von Material, während sich dieses noch in einem flüssigen Zustand befindet, entfernt wird.

16. Ein Herstellungsverfahren nach Anspruch 11, bei dem eine Mehrzahl von Primärspulen und eine Mehrzahl von Abschirmspulen aufgetragen werden, von denen jede auf eine andere im wesentlichen mit der besagten Längsachse konzentrisch ausgerichtete zylindrische Oberfläche aufgetragen wird.

17. Ein Herstellungsverfahren nach Anspruch 13, bei dem eine Mehrzahl von Primärspulen und eine Mehrzahl von Abschirmspulen aufgetragen werden, wobei jede Spule auf eine andere durch Hinzufügen von Material über zuvor gebildeten zylindrischen Oberflächen und aufgetragenen Spulen allmählich gebildete zylindrische Oberfläche aufgetragen wird.

## Revendications

1. Pour utilisation dans l'imagerie par résonance magnétique, jeu de bobinage à gradient comprenant; un membre plus ou moins cylindrique, un enroulement primaire entourant une surface cylindrique située sur ledit ou bien à l'intérieur dudit membre, ladite surface présentant un axe longitudinal et un enroulement de blindage; caractérisé en ce que ledit enroulement de blindage est placé autour d'une seconde surface cylindrique située sur ledit ou bien à l'intérieur dudit membre et à l'extérieur de ladite première surface cylindrique, ladite seconde surface cylindrique étant dans l'alignement plus ou moins concentrique de ladite surface cylindrique mentionnée en premier, pour maintenir ledit enroulement primaire et ledit enroulement de blindage dans un alignement relatif; et en ce que ledit membre est monobloc et généralement solide sur toute sa longueur, d'une rigidité et/ou d'une masse suffisantes pour assurer un accouplement en opposition de phase entre ledit enroulement primaire et ledit enroulement de blindage afin de réduire le bruit de fond.

2. Jeu de bobinage à gradient selon la revendication 1, caractérisé en outre en ce que ledit membre unitaire, plus ou moins cylindrique comprend une série de couches, chacune présentant une surface cylindrique dans un alignement relativement concentrique par rapport à ladite première surface cylindrique.

3. Jeu de bobinage à gradient selon la revendication 2, caractérisé en outre en ce que lesdites couches sont empilées par l'addition d'un matériau à l'extérieur dudit membre et enlèvement du matériau en surplus pour former ladite surface cylindrique concentrique.

4. Jeu de bobinage à gradient selon la revendication 3, caractérisé en outre en ce que ledit matériau est enlevé par travail au tour.

5. Jeu de bobinage à gradient selon la revendication 1, caractérisé en outre en ce que ledit membre unitaire comprend deux membres cylindriques, dont l'un supporte ledit enroulement primaire et dont l'autre supporte ledit enroulement de blindage, les membres cylindriques ayant été alignés pour amener ledit enroulement primaire et ledit enroulement de blindage dans un alignement relatif, et en ce qu'un matériau de remplissage a été injecté entre les membres de façon à les relier et également pour remplir au moins une partie de l'espace vacant entre lesdits membres.

6. Jeu de bobinage à gradient selon la revendication 1, caractérisé en outre en ce que ledit membre unitaire comprend un seul membre cylindrique dont les surfaces cylindriques intérieures et extérieures sont alignées de manière concentrique, en ce que ledit enroulement primaire est collé contre la surface cylindrique intérieure et en ce que ledit enroulement de blindage est collé contre la surface cylindrique extérieure.

7. Jeu de bobinage à gradient selon la revendication 1, caractérisé en outre en ce qu'il comprend un ou plusieurs enroulements primaires supplémentaires et un ou plusieurs enroulements de blindage supplémentaires, chacun des enroulements étant placé contre une surface cylindrique alignée de manière relativement concentrique par rapport auxdites premières et secondes surfaces cylindriques.

8. Jeu de bobinage à gradient selon la revendication 1, caractérisé en outre en ce qu'il comprend un enroulement de correction entourant ledit enroulement de blindage, ledit enroulement de correction éliminant plus ou moins le champ externe au jeu de bobinage à gradient, champ résultant des erreurs d'alignement entre ledit enroulement primaire et ledit enroulement de blindage.

9. Jeu de bobinage à gradient selon la revendication 1, caractérisé en outre en ce que ledit enroulement primaire est constitué de fil à brins isolés.

10. Jeu de bobinage à gradient selon la revendication 9, caractérisé en outre en ce que ledit enroulement de blindage est constitué de fil à brins isolés.

11. Procédé de fabrication de jeux de bobinages pour imagerie à résonance magnétique, ledite procédé de fabrication se décomposant comme suit :
(1) création d'une première surface cylindrique sur un membre unitaire, ladite première surface étant plus ou moins alignée par rapport à un axe longitudinal;
(2) création d'une seconde surface cylindrique sur un membre unitaire, ladite seconde surface étant plus ou moins alignée par rapport audit axe longitudinal;
(3) mise en place d'une bobine primaire sur ladite première surface cylindrique; et
(4) mise en place d'une bobine de blindage sur ladite seconde surface cylindrique;
ledit membre unitaire étant relativement solide sur toute sa longueur et présentant une rigidité et/ou une masse suffisantes pour assurer un accouplement en opposition de phase entre ledit enroulement primaire et ledit enroulement de blindage pour réduire le bruit de fond.

12. Procédé de fabrication selon la revendication 11, où ledit enroulement primaire est formé sur un mandrin, la surface dudit mandrin constituant ladite première surface cylindrique et où ledit membre est formé par l'addition d'un matériau sur ledit enroulement primaire pour constituer ladite seconde surface cylindrique.

13. Procédé de fabrication selon la revendication 12, où la quantité de matériau appliquée initialement sera volontairement généreuse et où il faudra retirer le surplus pour constituer ladite seconde surface cylindrique.

14. Procédé de fabrication selon la revendication 13 où le surplus de matériau est enlevé au tour.

15. Procédé de fabrication selon la revendication 13, où ledit matériau est enlevé par rotation dudit membre autour dudit axe longitudinal et enlèvement dudit matériau tandis qu'il est toujours à l'état liquide.

16. Procédé de fabrication selon la revendication 11, où un ensemble d'enroulements primaires et un ensemble d'enroulements de blindage sont appliqués, chacun des enroulements étant appliqué contre une surface cylindrique différente dans un alignement relativement concentrique par rapport audit axe longitudinal.

17. Procédé de fabrication selon la revendication 13, où un ensemble d'enroulements primaires et un ensemble d'enroulements de blindage sont appliqués, chacun des enroulements étant appliqué contre une surface cylindrique différente, par l'addition successive de matériau sur les surfaces cylindriques constituées précédemment et sur les enroulements appliqués.
